# EUROPEAN PATENT SPECIFICATION

(11) **EP 2 668 471 B1**
(45) Date of publication and mention of the grant of the patent: **30.03.2016**
(21) Application number: 11701127.0
(22) Date of filing: 26.01.2011
(51) Int. Cl.: G01D 21/00, G05B 19/042

(54) **DIAGNOSIS OF PHYSICAL-LAYER BUS PARAMETERS IN A FILLING LEVEL MEASURING DEVICE**
DIAGNOSE VON BUS PARAMETERN DER PHYSIKALISCHEN SCHICHT IN EINEM FÜLLSTANDMESSGERÄT.
DIAGNOSTIQUE DE PARAMETRES DE BUS DE LA COUCHE PHYSIQUE DANS UN DISPOSITIF DE MESURE DE NIVEAU DE REMPLISSAGE.

(43) Date of publication of application: 04.12.2013
(73) Proprietor: VEGA Grieshaber KG, 77709 Wolfach (DE)
(72) Inventor: GÜNTER, Klaus, 78733 Aichhalden (DE)
(74) Representative: Maiwald Patentanwalts GmbH
(86) International application number: PCT/EP2011/051048
(87) International publication number: WO 2012/100821

(56) References cited:
- WO-A1-2010/076164
- DE-A1-102008 029 956

## Description

The invention relates to the field of field devices. In particular, the invention relates to a filling level measuring device for connection to a field bus, a pressure measuring device, a flow measure device, a method for monitoring a signal, a program element and a computer-readable medium.

### Technological background of the invention

When visualizing or analyzing field bus signals, visualization and/or analyzation devices are connected to the field bus. These devices may also be called diagnosis tools and may be used when the field device is activated for the first time in its measurement environment, or for monitoring the field bus system.

For each field bus segment an individual diagnosis tool may have to be used (each diagnosis tool needing an extra interface for connecting to the field bus segment).

DE 10 2008 029 956 A1 describes a measuring system with a sensor module and a transmitter module. A primary signal is transformed in a sensor signal which is, in turn, converted into a message which can be transmitted wirelessly.

WO 2010/076164 A1 describes a method for transferring parameter data during uploading and/or downloading of parameter settings between field devices and/or a control center.

### Summary of the invention

It would be desirable to provide for an easy to perform and flexible diagnosis of physical-layer (field bus) parameters of a field bus signal.

The invention provides a filling level measuring device, a pressure measuring device, a flow measuring device, a method, a program element and a computer-readable medium according to the features of the independent claims. Exemplary embodiments of the invention are stated in the dependent claims and in the following description.

It should be noted that features which are in the following described with respect to the filling level measuring device may also be implemented in the pressure measuring device, in the flow measure device or as method steps in the method, the program element and the computer-readable medium, and vice versa.

According to a first aspect of the invention, a filling level measuring device for connection to a field bus is provided, wherein the device comprises a processing unit which is adapted for monitoring a signal which is intended for being transmitted from the filling level measuring device to another device which is connected to the field bus, or which is received by the filling level measuring device from the other device. Furthermore, the processing unit is adapted for determining one or more physical layer parameters of the signal.

In other words, a field bus signal can be monitored inside the filling level measuring device and can be analyzed, also inside the device, by determining one or more physical layer parameters of the signal.

No external diagnosis tool is necessary.

According to an exemplary embodiment of the invention, the one or more physical layer parameters are selected from the group comprising a voltage applied to the bus, an amplitude of the signal, a form of the signal, an amplitude of a noise of the signal, and a frequency of a signal which generates the noise.

According to another exemplary embodiment of the invention, the filling level measuring device further comprises a data storage for storing the signal and/or the one or more physical layer parameters.

According to another exemplary embodiment of the invention, the device further comprises an analog-to-digital converter for digitizing the signal before it is stored in the data storage.

According to another exemplary embodiment of the present invention, the processing unit is further adapted for identifying the other device which has transmitted the signal to the filling level measuring device.

In other words, filling level measuring device can determine physical layer parameters of field bus signals transmitted from other devices.

According to another exemplary embodiment of the present invention, the device further comprises a long-term data storage in which the physical layer parameters are stored after they have been determined.

This long-term data storage may be part of or identical with the data storage in which the field bus signal is stored.

According to another exemplary embodiment of the present invention, the device is further adapted for transmitting the determined one or more physical layer parameters via the field bus to a user upon request of the user.

In other words, the device determines the physical layer parameters and a user, who needs information about the physical layer parameters, may request the device to transmit the parameters.

According to another exemplary embodiment of the present invention, the device further comprises an indicating and adjustment module adapted for visualizing the determined one or more physical layer parameters. Such an indicating and adjustment module may be connected to an interface of the filling level measurement device and may comprise a display displaying information (such as physical layer parameters) and also a user interface for device parameterization.

According to another exemplary embodiment of the present invention, the device further comprises an interface adapter adapted for connecting the device to an external computer and for transmitting the determined one or more physical layer parameters to the external computer.

Therefore, the physical layer parameters may not need to be transmitted via the field bus to the user but may (alternatively or additionally) visualized at the device (via the indicating and adjustment module) or on a computer connected to the device.

In the latter case, the physical layer parameters may be visualized by using device type manager tools (DTMs).

Thus, the physical layer parameters can be visualized even if a field bus system is not working properly.

According to another exemplary embodiment of the present invention, the device is further adapted for generating and transmitting a status report relating to a status of the field device based on the analysis of the one or more physical layer parameters.

According to another exemplary embodiment of the present invention, the device is adapted for performing a fast Fourier Transformation of a noise of the signal in order to identify a frequency of a signal generating the noise.

According to another exemplary embodiment of the present invention, the field bus uses as protocol for data transmission one of a profibus protocol, a fieldbus foundation protocol and a HART protocol.

According to another aspect of the invention, a pressure measuring device for connection to a field bus is provided, which comprises the above and below described processing unit.

According to another aspect of the invention, a flow measuring device for connection to a field bus is provided, which comprises the above and below described processing unit.

According to another aspect of the invention, a method for monitoring a signal by a filling level measuring device, a pressure measuring device or a flow measuring device is provided, wherein the signal is intended for being transmitted from the filling level measuring device, the pressure measuring device or the flow measuring device to another device connected to the field bus or which is received by the filling level measuring device, the pressure measuring device or the flow measuring device from the other device. In this method, a monitoring of the signal is performed by the device and one or more physical layer parameters of the signal are determined by the device.

According to another aspect of the invention, a program element is provided, which, when being executed by a processor of a filling level measuring device, a pressure measuring device or a flow measuring device instructs the processor to carry out the above and below described method steps.

According to another aspect of the invention, a computer-readable medium is provided, on which a program element is stored, which, when being executed by a processor of a filling level measuring device, a pressure measuring device or a flow measuring device instructs the processor to carry out the above and below described method steps.

It may be seen as a gist according to an exemplary embodiment of the invention that field bus diagnosis can be performed by the field device, i.e. the pressure measuring device, the flow measuring device or the filling level measuring device, without the need for external diagnosis tools. Furthermore, physical layer parameters which have been determined by the field device can be transmitted to an external user via the field bus, can be visualized by an indicating an adjustment module connected to the field device and can also be visualized and analyzed by a computer connected to an interface of the field device.

These and other aspects of the present invention will become apparent from and elucidated with reference to the embodiments described hereinafter.

Exemplary embodiments of the present invention will now be described in the following, with reference to the following drawings.

### Brief description of the drawings

Fig. 1 shows a field device, to which a computer is connected, according to an exemplary embodiment of the present invention.
Fig. 2 shows a field bus system according to another exemplary embodiment of the present invention.
Fig. 3 shows a flow-chart of a method according to an exemplary embodiment of the present invention.
Fig. 4 shows a signal and corresponding physical layer parameters of the signal which are determined according to an exemplary of the present invention.

### Detailed description of embodiments

The illustration in the drawings is schematically. In different drawings, similar or identical elements are provided with the same reference numerals.

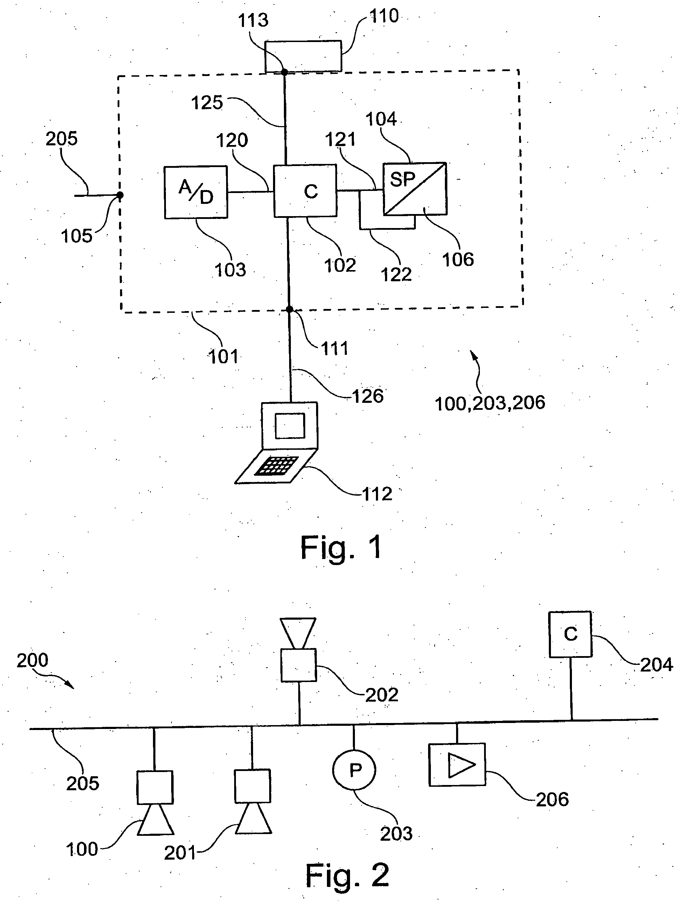

Fig. 1 shows a field device, such as a filling level measuring device 100, a pressure measuring device 203, or a flow measuring device 206.

The device comprises a housing 101, which comprises an interface 105 for connecting the device to a field bus 205. Furthermore, a second interface 111 may be provided for connecting the device to an external computer 112. Still further, a third interface 113 may be provided at the housing for connecting the device to an indicating and adjustment module 110.

The field device 100, 203, 206 comprises an analog-to-digital converter 103 which is adapted for digitizing the field bus signal. The converter 103 is connected, via connection 120, to a microprocessor 102 und/or to a data storage 104, 106 (not depicted in fig. 1). The data storage may comprise a short-term data storage section 104 and a long-term data storage section 106. Alternatively, two separate data storage devices 104, 106 may be provided or only one long-term storage.

The microprocessor 102 is connected via lines 121, 122 to both data storage sections 104, 106. The third interface and second interface are connected to the processor 102 via connection lines 125 and 126, respectively.

The processor 102 is programmed to carry out the above and below described method steps. Thus, the incoming and outgoing bus signals can be stored in the data storage 104 and/or in the long-term data storage 106. Then, the processor 102 analyzes the stored data, identifies, if necessary, the source of the data, i.e. the field device which transmitted the corresponding signals to field device 100, 203, 206, and calculates the physical layer parameters of the field bus signal, which are needed for diagnosis.

The determined physical layer parameters may then be stored in the long-term data storage 106 and may be visualized and/or read-out via a DTM tool.

Furthermore, the physical layer parameters may be displayed by an indicating an adjustment module 110 connected to the field device via the third interface 113.

Still further, the physical layer parameters may be transmitted to other field devices via the field bus 205, for example upon user request.

It should be noted that various conditions of the field device 100, 203, 206 or of the external field device which has been transmitted the signal can be transmitted to an external analyzing system 204 (see Fig. 2) for further analysis for asset management.

It should be noted that for implementation of the invention into a filling level measuring device already existent microcontrollers, analog-digital converters and storage media may be used. Thus, no extensive hardware changes may have to be performed when implementing the invention in currently known devices.

An advantage of the invention is that no additional first diagnosis tools are necessary and that no additional field bus interface for connecting the diagnosis tool to the field bus has to be applied. Thus, hardware may be reduced for diagnosis purposes.

Furthermore, each field bus segment has a field bus diagnosis function which is automatically provided by the field device of this respective field bus segment.

By analyzing physical layer parameters of the field bus signals continuous changes of the condition of a field bus device, such as the filling level measuring device or a passive device, such as an interface, a distribution device or a plug, may be detected, such as, for example, ongoing corrosion of electric interface contacts. These changes can then be brought to the attention of an external analyzing or control unit 204, which is connected to the field bus, via a transmission of corresponding status signals. These status signals may be transmitted on the initiative of the filling level measuring device if changes in the condition of a filling level measuring device are detected by analyzing the determined physical layer parameters inside the filling level measuring device.

With the help of a fast Fourier Transform analysis of the signal noise it is possible to identify frequencies of the signals which are responsible for the noise. By doing so, the user may identify a source of the noise such as, for example, a particular frequency converter of an electric motor which is located in the vicinity of the filling level measuring device.

Fig. 2 shows a field bus system 200, which comprises a field bus 205 and several field devices connected to the field bus 205. For example, three filling level measurement devices 100, 201, 202 (such as filling level radars), a pressure measuring device 203, a flow measuring device 206 and an external analysis unit 204.

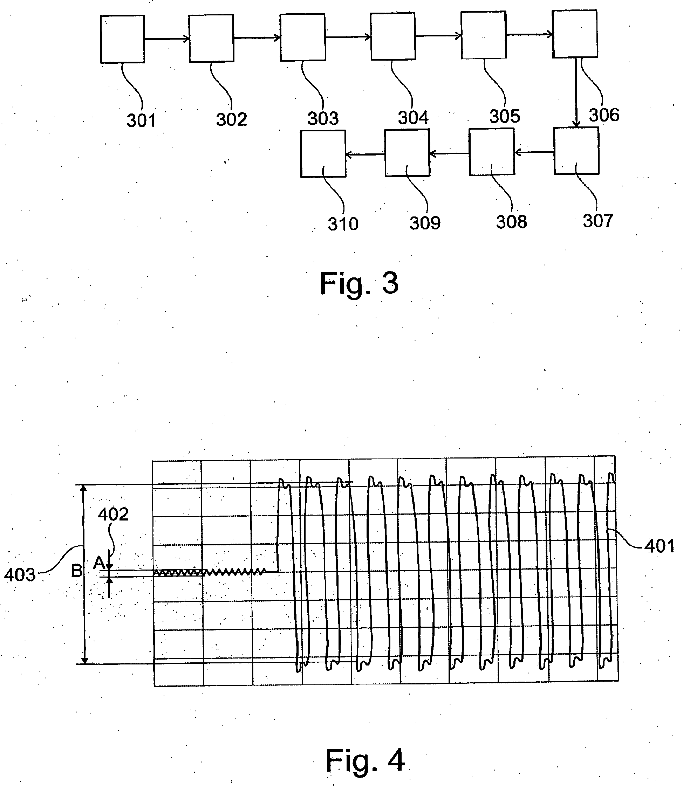

Fig. 3 shows a flow-chart of a method according to an exemplary embodiment of the invention. In step 301 a field bus signal is generated inside the filling level measuring device or received from another field device by the filling level measuring device.

Then, in step 302, this signal is digitized and in step 303 stored in a data storage. In step 304 the stored signal is analyzed by a microprocessor and physical layer parameters of the signal are determined in step 305. In step 306 it is determined by comparing the physical layer parameters with corresponding physical layer parameters which have been acquired earlier, that the filling level measuring device has a defect. In step 307 a corresponding status report is transmitted to an external recipient 204 (see Fig. 2). In step 308 the user requests the device to transmit further physical layer parameters which are determined from other signals and in step 310 the external device performs an analysis of the parameters and a determines whether the corresponding filling level measuring device is working properly or not, i.e. a diagnosis.

Fig. 4 shows a signal 401 which has been received by the filling level measuring device via the field bus or which is intended to be transmitted via the field bus from the filling level measuring device to another field device. This signal 401 is analyzed by the filling level measuring device and physical layer parameters are determined from this signal. For example, an amplitude 402 of signal noise and an amplitude 403 of the signal 401 are determined.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. Filling level measuring device (100) for connection to a field bus (205), the device (100) comprising:
a processing unit (102);
wherein the processing unit (102) is adapted for:
monitoring a signal which is intended for being transmitted from the filling level measuring device (100) to another device (201, 202, 203, 204, 206) connected to the field bus (205) or which is received by the filling level measuring device (100) from the other device (201, 202, 203, 204); and
determining one or more physical layer parameters of the signal.

2. The device of claim 1,
wherein the one or more physical layer parameters are selected from the group comprising a voltage applied to the bus, an amplitude of the signal, a form of the signal, an amplitude of a noise of the signal, and a frequency of a signal which generates the noise.

3. The device of claim 1 or 2, further comprising:
a data storage (104, 106) for storing the signal and/or the one or more physical layer parameters.

4. The device of one of the preceding claims,
wherein the processing unit (102) is further adapted for identifying the other device (201, 202, 203, 204).

5. The device of one of the preceding claims, further adapted for transmitting the determined one or more physical layer parameters via the field bus (205) to a user (201, 202, 203, 204) upon request of the user (201, 202, 203, 204).

6. The device of one of the preceding claims, further comprising an indicating and adjustment module (110) adapted for visualizing the determined one or more physical layer parameters.

7. The device of one of the preceding claims, further comprising an interface adapter (111) adapted for connection to an external computer (112) and for transmitting the determined one or more physical layer parameters to the external computer (112).

8. The device of one of the preceding claims, further adapted for generating and transmitting a status report relating to a status of the filling level measuring device (100) based on the analysis of the one or more physical layer parameters.

9. The device of one of the preceding claims, further adapted for performing a fast Fourier transformation of a noise of the signal in order to identify a frequency of a signal generating the noise.

10. The device of one of the preceding claims,
wherein the field bus uses as protocol for data transmission one of a profibus protocoll, a fieldbus foundation protocoll and a HART protocoll.

11. A pressure measuring device (203) for connection to a field bus (205), the device (203) comprising:
a processing unit (102);
wherein the processing unit (102) is adapted
for monitoring a signal which is intended for being transmitted from the pressure measuring device (203) to another device (100, 201, 202, 206, 204) connected to the field bus (205) or which is received by the pressure measuring device (203) from the other device (100, 201, 202, 206, 204); and
for determining one or more physical layer parameters of the signal.

12. A flow measuring device (206) for connection to a field bus (205), the device (203) comprising:
a processing unit (102);
wherein the processing unit (102) is adapted
for monitoring a signal which is intended for being transmitted from the flow measuring device (206) to another device (100, 201, 202, 203, 204) connected to the field bus (205) or which is received by the flow measuring device (206) from the other device (100, 201, 202, 203, 204); and
for determining one or more physical layer parameters of the signal.

13. A method for monitoring a signal by a filling level measuring device, a pressure measuring device or a flow measuring device (206), wherein the signal is intended for being transmitted from the filling level measuring device (100), the pressure measuring device (203) or the flow measuring device (206) to another device (201, 202, 203, 204) connected to the field bus (205) or which is received by the filling level measuring device (100), the pressure measuring device or the flow measuring device (206) from the other device (100, 201, 202, 203, 204, 206), the method comprising the steps of:
monitoring the signal;
determining one or more physical layer parameters of the signal.

14. A program element, which, when being executed by a processor (102) of a filling level measuring device (100), a pressure measuring device (203) or a flow measuring device (206) instructs the processor (102) to carry out the method steps of claim 13.

15. A computer-readable medium, on which a program element is stored, which, when being executed by a processor (102) of a filling level measuring device (100), a pressure measuring device (203) or a flow measuring device (206) instructs the processor (102) to carry out the method steps of claim 13.

## Patentansprüche

1. Füllstandsmessgerät (100) zum Verbinden an einen Feldbus (205), wobei das Gerät (100) Folgendes umfasst:
eine Prozessoreinheit (102);
wobei die Prozessoreinheit (102) angepasst ist zum:
Überwachen eines Signals, welches bestimmt ist, von dem Füllstandsmessgerät (100) an ein anderes mit dem Feldbus (205) verbundenes Gerät (201, 202, 203, 204, 206) übermittelt zu werden oder welches durch das Füllstandsmessgerät (100) von dem anderen Gerät (201, 202, 203, 204) empfangen wird; und
Bestimmen eines oder mehrerer Parameter der physikalischen Schicht des Signals.

2. Gerät nach Anspruch 1,
wobei der eine oder die mehreren Parameter der physikalischen Schicht ausgewählt sind aus der Gruppe umfassend eine an den Bus angelegte Spannung, eine Amplitude des Signals, eine Form des Signals, eine Amplitude eines Rauschen des Signals und eine Frequenz eines Signals, welches das Rauschen erzeugt.

3. Gerät nach Anspruch 1 oder 2, Folgendes umfassend:
einen Datenspeicher (104, 106) zum Speichern des Signals und/oder des einen oder der mehreren Parameter der physikalischen Schicht.

4. Gerät nach einem der vorhergehenden Ansprüche,
wobei die Prozessoreinheit (102) ferner angepasst ist zum Identifizieren des anderen Geräts (201, 202, 203, 204).

5. Gerät nach einem der vorhergehenden Ansprüche, ferner angepasst zum Übermitteln des einen oder der mehreren bestimmten Parameter der physikalischen Schicht über den Feldbus (205) an einen Benutzer (201, 202, 203, 204) auf Anfrage des Benutzers (201, 202, 203, 204).

6. Gerät nach einem der vorhergehenden Ansprüche, ferner umfassend ein Anzeige- und Einstellmodul (110), angepasst zum Visualisieren des einen oder der mehreren bestimmten Parameter der physikalischen Schicht.

7. Gerät nach einem der vorhergehenden Ansprüche, ferner umfassend einen Schnittstellenadapter (111), angepasst zum Verbinden an einen externen Computer (112) und zum Übermitteln des einen oder der mehreren bestimmten Parameter der physikalischen Schicht an den externen Computer (112).

8. Gerät nach einem der vorhergehenden Ansprüche, ferner angepasst zum Erzeugen und zum Übermitteln eines Statusberichts mit Bezug auf einen Status des Füllstandsmessgeräts (100) auf der Grundlage der Analyse des einen oder der mehreren Parameter der physikalischen Schicht.

9. Gerät nach einem der vorhergehenden Ansprüche, ferner angepasst zum Ausführen einer schnellen Fourier-Transformation eines Rauschens des Signals, um eine Frequenz eines Signals zu identifizieren, das das Rauschen erzeugt.

10. Gerät nach einem der vorhergehenden Ansprüche,
wobei der Feldbus als Protokoll zur Datenübertragung ein Profibus-Protokoll, ein Fieldbus-Foundation-Protokoll und/oder ein HART-Protokoll nutzt.

11. Druckmessgerät (203) zum Verbinden an einen Feldbus (205), wobei das Gerät (203) Folgendes umfasst:
eine Prozessoreinheit (102);
wobei die Prozessoreinheit (102) angepasst ist
zum Überwachen eines Signals, welches bestimmt ist, von dem Druckmessgerät (203) an ein anderes mit dem Feldbus (205) verbundenes Gerät (100, 201, 202, 206, 204) übermittelt zu werden oder welches durch das Druckmessgerät (203) von dem anderen Gerät (100, 201, 202, 206, 204) empfangen wird; und
zum Bestimmen eines oder mehrerer Parameter der physikalischen Schicht des Signals.

12. Strömungsmessgerät (206) zum Verbinden an einen Feldbus (205), wobei das Gerät (203) Folgendes umfasst:
eine Prozessoreinheit (102);
wobei die Prozessoreinheit (102) angepasst ist
zum Überwachen eines Signals, welches bestimmt ist, von dem Strömungsmessgerät (206) an ein anderes mit dem Feldbus (205) verbundenes Gerät (100, 201, 202, 203, 204) übermittelt zu werden oder welches durch das Strömungsmessgerät (206) von dem anderen Gerät (100, 201, 202, 203, 204) empfangen wird; und
zum Bestimmen eines oder mehrerer Parameter der physikalischen Schicht des Signals.

13. Verfahren zum Überwachen eines Signals über ein Füllstandsmessgerät, ein Druckmessgerät oder ein Strömungsmessgerät (206), wobei das Signal dazu bestimmt ist, von dem Füllstandsmessgerät (100), dem Druckmessgerät (203) oder dem Strömungsmessgerät (206) an ein anderes mit dem Feldbus (205) verbundenes Gerät (201, 202, 203, 204) übermittelt zu werden oder welches durch das Füllstandsmessgerät (100), das Druckmessgerät oder das Strömungsmessgerät (206) von dem anderen Gerät (100, 201, 202, 203, 204, 206) empfangen wird, wobei das Verfahren die folgenden Schritte umfasst:
Überwachen des Signals;
Bestimmen eines oder mehrerer Parameter der physikalischen Schicht des Signals.

14. Programmelement, welches, wenn durch einen Prozessor (102) eines Füllstandsmessgeräts (100), eines Druckmessgeräts (203) oder eines Strömungsmessgeräts (206) ausgeführt, den Prozessor (102) anweist, die Verfahrensschritte nach Anspruch 13 auszuführen.

15. Computerlesbares Medium, auf dem ein Programmelement gespeichert ist, welches, wenn durch einen Prozessor (102) eines Füllstandsmessgeräts (100), eines Druckmessgeräts (203) oder eines Strömungsmessgeräts (206) ausgeführt, den Prozessor (102) anweist, die Verfahrensschritte nach Anspruch 13 auszuführen.

## Revendications

1. Dispositif de mesure de niveau de remplissage (100) en vue de la connexion à un bus de terrain (205), le dispositif (100) comportant :
une unité de traitement (102) ;
dans lequel l'unité de traitement (102) est adaptée pour :
surveiller un signal qui est destiné à être transmis depuis le dispositif de mesure de niveau de remplissage (100) à un autre dispositif (201, 202, 203, 204, 206) relié au bus de terrain (105) ou lequel est reçu par le dispositif de mesure de niveau de remplissage (100) en provenance de l'autre dispositif (201, 202, 203, 204) ; et
déterminer un ou plusieurs paramètres de couche physique du signal.

2. Dispositif selon la revendication 1,
dans lequel le ou les paramètres de couche physique sont choisis parmi le groupe comprenant une tension appliquée au bus, une amplitude du signal, une forme du signal, une amplitude d'un bruit du signal, et une fréquence d'un signal qui génère le bruit.

3. Dispositif selon la revendication 1 ou 2, comportant en outre :
une mémoire de données (104, 106) pour mémoriser le signal et/ou le ou les paramètres de couche physique.

4. Dispositif selon l'une des revendications précédentes,
dans lequel l'unité de traitement (102) est en outre adaptée pour identifier l'autre dispositif (201, 202, 203, 204).

5. Dispositif selon l'une de revendications précédentes, adapté en outre pour transmettre le ou les paramètres de couche physique déterminés via le bus de terrain (205) à un utilisateur (201, 202, 203, 204) à la demande d'un utilisateur (201, 202, 203, 204).

6. Dispositif selon l'une des revendications précédentes, comportant en outre un module d'indication et de réglage (110) adapté pour visualiser le ou les paramètres de couche physique déterminés.

7. Dispositif selon l'une des revendications précédentes, comportant en outre un adaptateur d'interface (111) adapté en vue d'une connexion à un ordinateur externe (112) et pour transmettre le ou les paramètres de couche physique déterminés à l'ordinateur externe (112).

8. Dispositif selon l'une des revendications précédentes, adapté en outre pour générer et transmettre une notification d'état concernant un état du dispositif de mesure de niveau de remplissage (100) sur la base de l'analyse du ou des paramètres de couche physique.

9. Dispositif selon l'une des revendications précédentes, adapté en outre pour exécuter une transformation de Fourier rapide d'un bruit du signal afin d'identifier une fréquence d'un signal générant le bruit.

10. Dispositif selon l'une de revendications précédentes,
dans lequel le bus de terrain utilise en tant que protocole pour la transmission de données l'un d'un protocole Profibus, d'un protocole de fondation de bus de terrain et d'un protocole HART.

11. Dispositif de mesure de pression (203) en vue de la connexion à un bus de terrain (205), le dispositif (203) comprenant :
une unité de traitement (102) ;
dans lequel l'unité de traitement (102) est adaptée :
pour surveiller un signal qui est destiné à être transmis depuis le dispositif de mesure de pression (203) à un autre dispositif (100, 201, 202, 206, 204) relié au bus de terrain (205) ou lequel est reçu par le dispositif de mesure de pression (203) en provenance de l'autre dispositif (100, 201, 202, 206, 204) ; et
pour déterminer un ou plusieurs paramètres de couche physique du signal.

12. Dispositif de mesure d'écoulement (106) en vue d'une connexion à un bus de terrain (205), le dispositif (203) comportant :
une unité de traitement (102) ;
dans lequel l'unité de traitement (102) est adaptée :
pour surveiller un signal qui est destiné à être transmis depuis le dispositif de mesure de niveau de remplissage (206) à un autre dispositif (201, 202, 203, 204) relié au bus de terrain (205) ou lequel est reçu par le dispositif de mesure de niveau de remplissage (206) en provenance de l'autre dispositif (201, 202, 203, 204) ; et
pour déterminer un ou plusieurs paramètres de couche physique du signal.

13. Procédé pour surveiller un signal par l'intermédiaire d'un dispositif de mesure de niveau de remplissage, un dispositif de mesure de pression ou un dispositif de mesure d'écoulement (206), dans lequel le signal est destiné à être transmis depuis le dispositif de mesure de niveau de remplissage (100), le dispositif de mesure de pression (203) ou le dispositif de mesure d'écoulement (206) à un autre dispositif (201, 202, 203, 204) relié au bus de terrain (205) ou lequel est reçu par le dispositif de mesure de niveau de remplissage (100), le dispositif de mesure de pression ou le dispositif de mesure d'écoulement (206) en provenance de l'autre dispositif (100, 201, 202, 203, 204, 206), le procédé comportant les étapes consistant à :
surveiller le signal ;
déterminer un ou plusieurs paramètres de couche physique du signal.

14. Élément de programme, lequel, lorsqu'il est exécuté par un processeur (102) d'un dispositif de mesure de niveau de remplissage (100), d'un dispositif de mesure de pression (103) ou d'un dispositif de mesure d'écoulement (206) ordonne au processeur (102) de mettre en oeuvre les étapes du procédé de la revendication 13.

15. Support lisible par ordinateur, sur lequel un élément de programme est mémorisé, lequel, lorsqu'il est exécuté par un processeur (102) d'un dispositif de mesure de niveau de remplissage (100), d'un dispositif de mesure de pression (103) ou d'un dispositif de mesure d'écoulement (206) ordonne au processeur (102) de mettre en oeuvre les étapes du procédé de la revendication 13.
